# EUROPÄISCHE PATENTANMELDUNG

(11) **EP 0 817 537 A2**
(43) Veröffentlichungstag der Anmeldung: **07.01.1998**
(21) Anmeldenummer: 97110255.3
(22) Anmeldetag: 23.06.1997
(51) Int. Cl.: H05B 33/10

(54) **Elektrolumineszierende Anordnungen enthaltend plasmabehandelte Basiselektrode**

(30) Priorität: 05.07.1996 DE 19627068
(71) Anmelder: BAYER AG, 51368 Leverkusen (DE); Robert Bosch GmbH, 70469 Stuttgart (DE)
(72) Erfinder: Elschner, Andreas, Dr., 45479 Mühlheim a.d.Ruhr (DE); Wehrmann, Rolf, Dr., 47800 Krefeld (DE); Thurm, Siegfried, Dr., 40668 Meerbusch (DE); Hueppauff, Martin, Dr., 70563 Stuttgart (DE); Grothe, Brigitte, 75233 Tiefenbronn (DE)
(74) Vertreter: Klimiuk-Japadita, Meike

(57) **Zusammenfassung**

Verfahren zur Reinigung der Basiselektrode einer elektrolumineszierenden Anordnung, wobei in einem Plasmareaktor vor Deposition der organischen Schicht die Basiselektrode einem Gasplasma ausgewählt aus Sauerstoff, Stickstoff, Argon, Helium, Neon, Xenon, Krypton sowie Gemische daraus, ausgesetzt wird.

## Beschreibung

Die vorliegende Erfindung betrifft organische elektrolumineszierende Anordnungen, bei denen die Basiselektrode vor dem Aufbringen der ersten Schicht einem Plasma ausgesetzt wurde.

Strombetriebene lichtemittierende Anordnungen haben in unserem optoelektronischen Zeitalter eine große Bedeutung. Die Entwicklung der optischen Anzeigeelemente zielt auf Anordnungen, die flach sind, großflächig betrieben werden können, eine hohe Effizienz besitzen und niedrig in den Herstellungskosten sind. Es gibt eine Anzahl von unterschiedlichen Möglichkeiten, elektrisch betriebene Lichtemittierende Anordnungen herzustellen. Es sind aber nur zwei Systemklassen bekannt, die die Anordnungen großflächig, flach und preisgünstige Herstellung, in sich vereinen.
1. Dotierte ZnS-Partikel in Bindermatrix
   Die ZnS-Partikel werden in eine dünne Schicht eingearbeitet und lumineszieren beim Anlegen eines hochfequenten elektrischen Feldes. Die Leuchtdiode der ZnS-Systeme ist niedrig. Ein weiterer Nachteil ist die notwendige hohe Betriebsspannung bei hoher Frequenz.
2. Elektrolumineszierende Polymere
   Polymere Leuchtdioden auf Basis von Poly-(Phenylen-Vinylen) wurden erstmalig von Friend et al. (S-P-5 247 190) beschrieben. Im einfachsten Aufbau wird das Polymer zwischen eine transparente Anode (z.B.: ITO) und eine aufgedampfte Kathode (z.B.: Ca, Al) gebracht. Die Anordnung emittiert beim Anlegen einer Spannung Licht.
3. Elektrlumineszierende Systeme. basierend auf niedermolekularen, aufgedampften Verbindungen
   LED's auf der Basis von aufgedampften, niedermolekularen Verbindungen wurden erstmalig 1983 von S. van Slyke und C. Tang beschrieben (EP-A 0 120 673). Die von den Autoren beschriebene LED besteht aus einer transparenten Anode (ITO) und zwei darauf aufgedampfte, niedermolekularen Schichten (Lochleiter, Elektronenleiter und Emitter), auf die eine metallische Kathode aufgedampft wird. Die Anordnung emittiert beim Anlegen einer Spannung von 10 bis 20 Volt Licht.

Der allgemeinste Fall für den Schichtaufbau in einer organischen LED ist in EP-A 0 637 899 angegeben. Dort werden auch zusätzliche Schichten beschrieben, die einen positiven Einfluß auf die Funktion der lichtemittierenden Anordnungen haben. Die Eigenschaften aus organischen Komponenten aufgebauter LED's lassen sich durch das Einfügen von zusätzlichen organischen Schichten deutlich verbessern (Tang et al., Appl. Phys. Lett. 51 (1987) 913). Dazu werden zwischen der elektrolumineszierenden Schicht und den beiden Elektroden eine oder zwei ladungsinjizierende Schichten eingefügt. Diese kann aus aufgedampften Monomeren (Adachi et al., Appl. Phys. Lett. 57 (1990) 531), Polymeren (US-P 5 231 329) oder aus Monomeren, dispergiert in Polymeren (Brown et al., Appl. Phys. Lett. 61 (1992) 2739), bestehen. Der prinzipielle Aufbau in der Reihenfolge der Schichten ist wie folgt:
1 Träger, Substrat
2 Basiselektrode
3 Löcher-injizierende Schicht
4 Löcher-transportierende Schicht
5 Licht-emittierende Schicht
6 Elektronen-transportierende Schicht
7 Elektronen-injizierende Schicht
8 Topelektrode
9 Kontakte
10 Umhüllung, Verkapselung.

Dieser Aufbau stellt den allgemeinsten Fall dar und kann vereinfacht werden, indem einzelne Schichten weggelassen werden, so daß eine Schicht mehrere Aufgaben übernimmt. Im einfachsten Fall besteht eine EL-Anordnung aus zwei Elektroden, zwischen denen sich eine organische Schicht befindet, die alle Funktionen - inklusive der der Emission von Licht - erfüllt. Derartige Systeme sind z.B. in der Anmeldung WO 90/13148 auf der Basis von Poly-(p-phenylenvinylen) beschrieben.

JP 07 220 873 beschreibt elektrolumineszierende Anordnungen und die Reinigung leitfähiger Substrate durch nachfolgende Behandlung mit oberflächenaktiven Agentien, Ultraschall, Säure- und Plasmabehandlung. Als Plasma-Gas werden beispielsweise Chlor oder Tetrachlorkohlenstoff genannt. Sauerstoff wird lediglich als Hilfsgas erwähnt.

Gegenstand der vorliegenden Erfindung ist ein Verfahren zur Reinigung der Basiselektrode einer elektrolumineszierenden Anordnung, wobei in einem Plasmareaktor vor Deposition der organischen Schicht die Basiselektrode einem Gasplasma ausgewählt aus Sauerstoff, Stickstoff, Argon, Helium, Neon, Xenon, Krypton sowie Gemische daraus, ausgesetzt wird.

Als Basiselektrode wird die Elektrode einer organischen LED bezeichnet, die auf das transparente Substrat aufgebracht wird. Die Basiselektrode ist meist ebenfalls transparent. Für organische LED's werden als Basiselektrode folgende Materialien verwendet:
a) Metalloxide, z.B. Indium-Zinn-Oxid (ITO), Zinnoxid (NESA), etc.,
b) semi-transparente Metallfilme, z.B. Au, Pt, Ag, Cu etc.,
c) leitfähige Polymerfilme wie Polyaniline, Polythiophene etc.

Die Metalloxid- und die semitransparenten Metallfilmelektroden werden durch Techniken wie Aufdampfen, Aufsputtern, Platinierung etc. in dünner Schicht aufgebracht.

Als Basiselektroden sind Metalloxide besonders geeignet. ITO- oder NESA-beschichtete Substrate werden von vielen Herstellern angeboten.

Nach dem Zuschneiden der Substrate auf ein gewünschtes Maß wird die Oberfläche der Basiselektrode auf dem Substrat mit organischen Lösungsmittels gründlich gereinigt. Nach der Reinigung werden die Substrate mit der Basiselektrode in den Plasmareaktor eingeführt.

Als Plasmareaktoren sind Apparaturen zu verstehen, in denen ein Niederdruckplasma gezündet und kontinuierlich brennen kann. Plasmareaktoren sind in der Vakuumtechnik allgemein verbreitet und vielfältig beschrieben (z.B. G. Franz: Kalte Plasmen, Springer-Verlag Berlin, 1990). Plasmareaktoren können kommerziell erworben oder selbst aufgebaut werden.

Der Einbau der Substrate in den Plasmareaktor erfolgt so, daß die Oberfläche der Basiselektrode vom Plasma erreicht wird. Nach Abpumpen des Reaktors auf einen Druck von in der Regel 10⁻⁴ mbar wird das Plasmagas eingelassen und das Plasma wird gezündet. Als Plasmagase werden O₂, N₂, Ar, He, Ne, Xe, Kr sowie Gemische dieser Gase, bevorzugt N₂ verwendet. Der zum Plasmabetrieb notwendige Gasdruck beträgt in der Regel 10⁻⁴ bis 10¹ mbar, die eingekoppelte Leistung 10 W - 10 kW. Nach einer ausreichenden Plasmaexpositionszeit werden die Substrate dem Reaktor entnommen und mit dem elektrolumineszierenden Polymer oder der 1. Schicht des elektrolumineszierenden Schichtsystems beschichtet. Die Plasmaexpositionszeit der Substrate beträgt im allgemeinen 1 s bis 10 h, vorzugsweise 30 s bis 60 min. Die Beschichtung der Basiselektrode erfolgt mit den bekannten Methoden wie Spincoating, Rakeln, Dipcoating etc.

### Beispiel 1

### Herstellung einer elektrolumineszierenden Anordnung, enthaltend plasmavorbehandelte Basiselektrode

A) ITO beschichtetes Glas (hergestellt von der Fa. Balzers) wird in 20 x 30 mm² große Stücke geschnitten und gereinigt. Dabei werden folgende Schritte sukzessive durchgeführt:
   1. 15 min mit destilliertem Wasser und Falterol im Ultraschallbad spülen,
   2. 2 x 15 min mit jeweils frischem destilliertem Wasser im Ultraschallbad spülen,
   3. 15 min mit Ethanol im Ultraschallbad spülen,
   4. 2 x 15 min mit jeweils frischem Aceton im Ultraschallbad spülen,
   5. Trocknen mit fusselfreien Linsentüchern.
B) Das ITO-beschichtete Glassubstrat wird mit der ITO-Schicht nach oben auf dem rotierbaren Substrathalter befestigt, welcher sich in einem evakuierbaren Kessel befindet. Anschließend wird der Kessel geschlossen und mittels eines Pumpstandes, bestehend aus einer Drehschieberpumpe TRIVAC D65 BCS-PFPE und einer Wälzkolbenpumpe RUVAC WS151 PFPE, beide von der Firma Leybold AG, Hanau, auf einen Druck von 5 x 10⁻⁴ mbar evakuiert. Danach wird der Substrathalter mit 20 Umdrehungen pro Minute rotiert und Sauerstoff mit einer Durchflußmenge von 200 Standard-cm³ pro Minute eingelassen, so daß in den Rezipienten ein O₂-Druck von 0,1 mbar herrscht. 70 mm oberhalb der Substrathalter befindet sich in dem Deckel des Rezipienten eine 50 mm x 15 mm große Öffnung, welche mittels einer 10 mm dicken Quarz-Platte gasdicht abgeschlossen ist. Durch diese Quarz-Platte wird mittels einer Hornantenne Mikrowellen-Strahlung der Frequenz 2,54 GHz mit einer Leistung von 200 W eingestrahlt und in dem Rezipienten ein O₂-Plasma gezündet. Nach 5 Minuten wird die Mikrowellen-Strahlung abgeschaltet, die O₂-Zugabe beendet, die Drehung des Substrathalters gestoppt, der Rezipient wieder auf ca. 1 x 10⁻³ mbar evakuiert, anschließend von den Pumpen durch Schließen eines Ventils entkoppelt und mit Stickstoff bis auf Normaldruck beflutet. Der Rezipient wird geöffnet und die erfindungsgemäß vorbehandelte Glasplatte mit der ITO-Schicht entnommen.
C) Eine 1%ige Dichlorethanlösung, bestehend aus Polyvinylcarbazol (PVK) und Cumarin im Gew.-Verhältnis von 3 Teilen PVK und 1 Teil Cumarin wird filtriert (0,2 µm Filter, Fa. Sartorius). Die filtrierte Lösung wird auf dem erfindungsgemäß vorbehandelten ITO-Substrat mit einer Lackschleuder bei 1000 U/min verteilt. Die Dicke der trocknenen Polymerschicht beträgt 120 nm.
D) Die Polymerschicht wird gründlich bei 50°C für 2 Stunden in einem Vakuumtrockenschrank getrocknet. Anschließend werden Al-Elektroden aufgedampft. Dazu werden mit Hilfe einer Lochmaske isolierte Al-Punkte mit einem Durchmesser von etwa 3 mm gedampft. Während des Aufdampfens herrscht in der Aufdampfapparatur (Leybold) ein Druck von < 10⁻⁴ mbar.
E) Die ITO-Schicht und die Al-Elektrode werden über elektrische Zuführungen mit einer Spannungsquelle verbunden. Der positive Pol der Spannungsquelle ist mit dem ITO, der negative mit dem Al verbunden. Beim Einschalten der Spannung auf Werte zwischen 0 und 30 Volt fließt ein Strom und die Anordnung emittiert Licht.
F) Die Elektrolumineszenzintensität der plasmabehandelten LED ist um den Faktor von 100 höher als bei der nicht plasmabehandelten LED.

### Beispiel 2

A) wie A) Beispiel 1
B) Die nach A) gereinigten ITO-Substrate werden auf dem Boden des Plasma-Prozessors 100-E-SN 0150 der Fa. TePla, Kirchheim bei München, gelegt. Ein Faraday-Käfig wird über die Substrate gestellt und der Rezipient wird auf etwa 0,1 mbar evakuiert. Das Prozeßgas N₂ (Reinheit: 99,99) wird in den Reaktor eingelassen, so daß der Druck auf 1 mbar ansteigt. Das Plasma wird gezündet und 10 Minuten bei 400 Watt brennen gelassen. Anschließend wird der Rezipient belüftet und die erfindungsgemäß plasmabehandelten Substrate werden entnommen.
C) - E) siehe Beispiel 1
F) Die Elektrolumineszenzintensität der LED mit dem entsprechend B) plasmabehandelten ITO ist um den Faktor von 10 höher als mit ITO aber ohne Plasmabehandlung. Die Einsatzspannung der Elektrolumineszenz ist bei der plasmabehandelten Probe um 3 Volt niedriger als bei der unbehandelten.

### Beispiel 3

A) ITO-beschichtetes Glas (Balzers, Baltracon 255) wird in 2" x 2" große Substrate geschnitten. Bei der Reinigung werden folgende Schritte durchgeführt:
   1. Substrat mit Aceton abwischen.
   2. Substrat mit Mucasol-Lösung abwischen.
   3. Mit H₂O dest. abspülen und trockenschleudern.
   4. 10 Minuten in Mucasol-Lösung (60°C) mit Ultraschall behandeln.
   5. Mit H₂O dest. abspülen und trockenschleudern.
   6. 10 Minuten in H₂O dest. (60°C) mit Ultraschall behandeln.
   7. 10 Minuten in H₂O dest.-Kaskade wässern und trockenschleudern.
B) Das ITO-beschichtete Substrat wird aufrecht in einem Quarzglasständer in einen Faraday-Käfig gestellt, der sich im Rezipienten eines Plasma-Prozessors 300 E der Fa. TePla (Mikrowellenplasma) oder eines Plasma-Prozessors 9102 der Fa. GaSonics International (HF (Hochfrequenz)-Plasma) befindet. Der Rezipient wird auf etwa 0,5 mbar evakuiert. Das Prozeßgas Sauerstoff wird in den Reaktor eingelassen, so daß der Druck auf etwa 1,5 mbar ansteigt. Das Plasma wird gezündet und brennt 10 Minuten bei 300 Watt.
C) Eine 1%ige Dichlorethanlösung, bestehend aus Polyvinylcarbazol (PVK) und Cumarin im Verhältnis 4:1 wird filtriert und auf das erfindungsgemäß vorbehandelte ITO-Substrat aufgetragen mit einer Lackschleuder bei 400 U/min.
D) Anschließend werden MgAg(10:1)-Kathoden aufgedampft. Dazu wird mit Hilfe einer Lochmaske der Durchmesser der Kontakte definiert. Während des Aufdampfens beträgt der Druck etwa 10⁻⁵ mbar.
E) Die ITO-Schicht (Anode) und die Kathode werden über elektrische Zuführungen mit einer Spannungsquelle verbunden. Beim Einschalten der Spannung auf Werte zwischen 0 und 30 Volt fließt ein Strom und die Anordnung emittiert Licht.
F) Die Elektrolumineszenz der plasmabehandelten LED setzt bei einer Spannung ein, die um etwa 4 Volt niedriger ist als bei einer nicht plasmabehandelten LED. Außerdem verläuft die Kennlinie bei der erfindungsgemäß behandelten LED steiler als bei einer unbehandelten LED.

## Patentansprüche

1. Verfahren zur Reinigung der Basiselektrode einer elektrolumineszierenden Anordnung, wobei in einem Plasmareaktor vor Deposition der organischen Schicht die Basiselektrode einem Gasplasma ausgewählt aus Sauerstoff, Stickstoff, Argon, Helium, Neon, Xenon, Krypton sowie Gemische daraus, ausgesetzt wird.

2. Verfahren gemäß Anspruch 1, wobei Stickstoff als Gasplasma eingesetzt wird.

3. Verfahren gemäß Anspruch 1, wobei der im Plasmareaktor vorhandene Gasdruck 10⁻⁴ bis 10¹ mbar beträgt.

4. Elektrolumineszierende Anordnung, enthaltend eine Basiselektrode, welche nach dem Verfahren gemäß Anspruch 1 gereinigt ist.
